# EUROPEAN PATENT APPLICATION

(11) **EP 2 192 445 A1**
(43) Date of publication of application: **02.06.2010**
(21) Application number: 09014805.7
(22) Date of filing: 27.11.2009
(51) Int. Cl.: G03F 7/20

(54) **Exposure device and semiconductor device manufacturing method.**

(30) Priority: 28.11.2008 JP 2008305676
(71) Applicant: NEC Electronics Corporation, Kawasaki, Kanagawa 211-8668 (JP)
(72) Inventor: Koshitaka, Toshiaki, Kawasaki-shi Kanagawa 211-8668 (JP)
(74) Representative: Glawe, Delfs, Moll

(57) **Abstract**

A method of manufacturing a semiconductor device includes a first absorption step (S30), a releasing step (S40), a second absorption step (S50), and an exposure step (S60). In the first absorption step, a wafer chuck (170) of a wafer stage (160) absorbs the semiconductor wafer (200) to adjust the temperature of the semiconductor wafer. In the releasing step, the semiconductor wafer is released from the wafer chuck. In the second absorption step, a wafer chuck of a wafer stage for exposure absorbs the semiconductor wafer. In the exposure step, the semiconductor wafer is exposed.

## Description

The application is based on Japanese patent application No. 2008-305676, the content of which is incorporated hereinto by reference.

### BACKGROUND

### TECHNICAL FIELD

The present invention relates to a method of manufacturing a semiconductor device including a step of exposing and developing a film to be exposed, a program of executing exposure and development of film to be exposed, an exposure device, and a recording medium of storing the program.

### RELATED ART

In recent years, with the increasing miniaturization of semiconductor devices, there is an increasing demand for improving the positioning accuracy of an exposure device. Thermal expansion of the semiconductor wafer is one of the causes of the reduction in the positioning accuracy of the exposure device.

For example, Japanese Unexamined patent publication NO. 2006-344986 discloses a technique in which an interface unit interposed between a coating device and an exposure device adjusts the temperature of a semiconductor wafer. In addition, Japanese Published patent application A-11-251236 discloses a technique in which, before a semiconductor wafer is transported to a wafer holder and is absorbed and held by the wafer holder, the temperatures of the semiconductor wafer and the wafer holder are measured while the semiconductor wafer is being transported and the semiconductor wafer is absorbed and held by the wafer holder after the difference between the temperatures falls within a predetermined allowable range.

The present inventor has recognized as follows. In the exposure device, a wafer stage on which the semiconductor wafer is loaded includes a wafer chuck that absorbs the semiconductor wafer. When the temperature of the semiconductor wafer before being loaded on the wafer stage is different from the temperature of the wafer stage, the temperature of the semiconductor wafer varies after the semiconductor wafer is loaded on the wafer stage, which results in thermal expansion or thermal contraction. When there is an in-plane distribution in the thermal expansion or thermal contraction, the positioning accuracy of the exposure device is partially lowered.

### SUMMARY

In one embodiment, there is a provided a method of manufacturing a semiconductor device including: allowing a wafer chuck of a first wafer stage to absorb a semiconductor wafer to adjust the temperature of the semiconductor wafer; releasing the semiconductor wafer from the wafer chuck; allowing a wafer chuck of a wafer stage for exposure to absorb the semiconductor wafer; and exposing the semiconductor wafer.

When the temperature is adjusted in the first absorption step, the semiconductor wafer is partially pressed against the first wafer stage, and an in-plane distribution is likely to occur in the thermal expansion or thermal contraction of the semiconductor wafer. However, according to the above-mentioned embodiment of the invention, after the temperature of the semiconductor wafer is adjusted in the first absorption step, the semiconductor wafer is released from the wafer chuck once before the exposure step. In this way, the portion of the semiconductor wafer pressed against the first wafer stage is released. Therefore, even when an in-plane distribution occurs in the thermal expansion or thermal contraction of the semiconductor wafer, it is possible to remove or reduce the in-plane distribution.

In another embodiment, there is provided a program that is installed in a control unit of an exposure device including a wafer chuck which absorbs a semiconductor wafer and the control unit which controls the wafer chuck. The program causes the control unit to perform, before an exposure process: a first absorption process of allowing the wafer chuck to absorb the semiconductor wafer to adjust the temperature of the semiconductor wafer; a releasing process of releasing the semiconductor wafer from the wafer chuck; and a second absorption process of allowing the wafer chuck to reabsorb the semiconductor wafer.

In still another embodiment, there is provided a program that is installed in a control unit of an exposure device including a first wafer stage including a first wafer chuck which absorbs a semiconductor wafer, a second wafer stage for exposure including a second wafer chuck which absorbs the semiconductor wafer, a wafer moving mechanism which moves the semiconductor wafer, and the control unit which controls the wafer moving mechanism, the first wafer chuck, and the second wafer chuck. The program causes the control unit to perform, before an exposure process: a process of allowing the first wafer chuck of the first wafer stage to absorb the semiconductor wafer to adjust the temperature of the semiconductor wafer; a process of allowing the first wafer chuck to release the semiconductor wafer; a process of allowing the wafer moving mechanism to move the semiconductor wafer over the first wafer stage to the second wafer stage; and a process of allowing the second wafer chuck of the second wafer stage to absorb the semiconductor wafer.

In yet another embodiment, there is provided an exposure device including: a wafer chuck that absorbs a semiconductor wafer; and a control unit that controls the wafer chuck. Before an exposure process, the control unit performs a first absorption process of allowing the wafer chuck to absorb the semiconductor wafer to adjust the temperature of the semiconductor wafer, a releasing process of allowing the wafer chuck to release the semiconductor, and a second absorption process of allowing the wafer chuck to reabsorb the semiconductor wafer.

In still yet another embodiment, there is provided an exposure device including: a first wafer stage including a first wafer chuck that absorbs a semiconductor wafer; a second wafer stage for exposure including a second wafer chuck which absorbs the semiconductor wafer; a wafer moving mechanism that moves the semiconductor wafer; and a control unit that controls the wafer moving mechanism, the first wafer chuck, and the second wafer chuck. The control unit performs a process of allowing the first wafer chuck of the first wafer stage to absorb the semiconductor wafer to adjust the temperature of the semiconductor wafer, a process of allowing the first wafer chuck to release the semiconductor wafer, a process of allowing the wafer moving mechanism to move the semiconductor wafer over the first wafer stage to the second wafer stage, and a process of allowing the second wafer chuck of the second wafer stage to absorb the semiconductor wafer.

In yet still another embodiment, there is provided a recording medium including a program stored therein that is installed in a control unit of an exposure device including a wafer chuck which absorbs a semiconductor wafer and the control unit which controls the wafer chuck. The program causes the control unit to perform, before an exposure process: a first absorption process of allowing the wafer chuck to absorb the semiconductor wafer to adjust the temperature of the semiconductor wafer; a releasing process of allowing the wafer chuck to release the semiconductor wafer; and a second absorption process of allowing the wafer chuck to reabsorb the semiconductor wafer.

In still yet another embodiment, there is provided a recording medium including a program stored therein that is installed in a control unit of an exposure device including a first wafer stage including a first wafer chuck which absorbs a semiconductor wafer, a second wafer stage for exposure including a second wafer chuck which absorbs the semiconductor wafer, a wafer moving mechanism which moves the semiconductor wafer, and the control unit which controls the wafer moving mechanism, the first wafer chuck, and the second wafer chuck. The program causes the control unit to perform, before an exposure process: a process of allowing the first wafer chuck of the first wafer stage to absorb the semiconductor wafer to adjust the temperature of the semiconductor wafer; a process of allowing the first wafer chuck to release the semiconductor wafer; a process of allowing the wafer moving mechanism to move the semiconductor wafer over the first wafer stage to the second wafer stage; and a process of allowing the second wafer chuck of the second wafer stage to absorb the semiconductor wafer.

According to the above-mentioned embodiments of the invention, it is possible to prevent the occurrence in an in-plane distribution in the thermal expansion or thermal contraction of a semiconductor wafer after the semiconductor wafer is loaded on a wafer stage.

### BRIEF DESCRIPTION OF THE DRAWINGS

The above and other objects, advantages and features of the present invention will be more apparent from the following description of certain preferred embodiments taken in conjunction with the accompanying drawings, in which:
Fig. 1 is a flowchart illustrating a method of manufacturing a semiconductor device according to a first embodiment;
Fig. 2 is a diagram illustrating the structure of an exposure device used in the method of manufacturing the semiconductor device according to the first embodiment;
Fig. 3 is a plan view illustrating a wafer chuck;
Fig. 4 is a cross-sectional view taken along the line A-A' of Fig. 3;
Figs. 5A and 5B are cross-sectional views illustrating the operation of the wafer chuck;
Fig. 6 is a diagram illustrating the structure of an exposure-device according to a second embodiment;
Fig. 7 is a flowchart illustrating a method of manufacturing a semiconductor device using the exposure device shown in Fig. 6;
Fig. 8 is a diagram illustrating the structure of an exposure device according to a third embodiment; and
Fig. 9 is a flowchart illustrating a method of manufacturing a semiconductor device using the exposure device shown in Fig. 8.

### DETAILED DESCRIPTION OF PREFERRED EMBODIMENTS

The invention will be now described herein with reference to illustrative embodiments. Those skilled in the art will recognize that many alternative embodiments can be accomplished using the teachings of the present invention and that the invention is not limited to the embodiments illustrated for explanatory purposes.

Hereinafter, exemplary embodiments of the invention will be described with reference to the accompanying drawings. In the drawings, the same components are denoted by the same reference numerals, and a description thereof will not be repeated.

### (first embodiment)

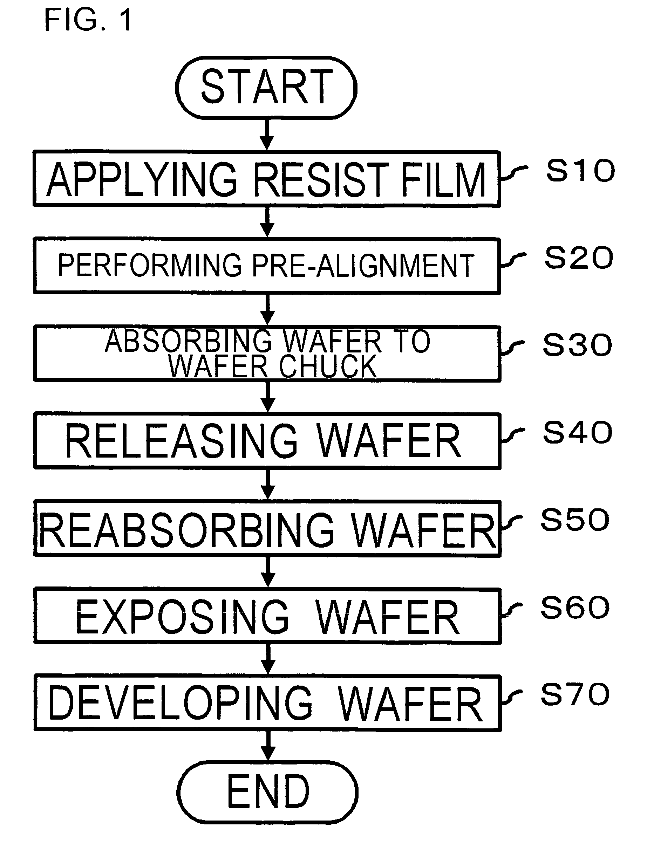

Fig. 1 is a flowchart illustrating a method of manufacturing a semiconductor device according to a first embodiment. The method of manufacturing the semiconductor device includes a first absorption step (Step S30), a releasing step (Step S40), a second absorption step (Step S50), and an exposure step (Step S60). In the first absorption step, a semiconductor wafer 200 is absorbed to a wafer chuck 170 of a wafer stage 160, and the temperature of the semiconductor wafer 200 is adjusted. In the releasing step, the semiconductor wafer 200 is released from the wafer chuck 170. In the second absorption step, the semiconductor wafer 200 is absorbed to a wafer chuck of a wafer stage for exposure. In the exposure step, the semiconductor wafer 200 is exposed. In this embodiment, the wafer stage for exposure is the wafer stage 160 for performing the first absorption step. Next, the method of manufacturing the semiconductor device will be described in detail.

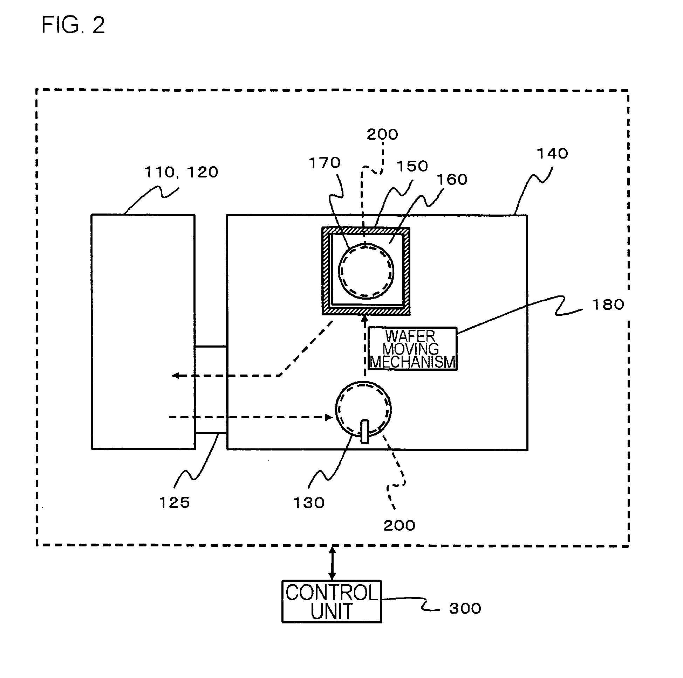

Fig. 2 is a diagram illustrating the structure of an exposure device 140 used in the method of manufacturing the semiconductor device according to the first embodiment. The exposure device 140 includes the wafer stage 160 and a control unit 300. The wafer stage 160 includes the wafer chuck 170 that absorbs the semiconductor wafer 200. The wafer stage 160 is disposed on the exposure stage 150, and a process of exposing the semiconductor wafer 200 is performed by the wafer stage 160. The control unit 300 controls the wafer chuck 170. Before the exposure process, the control unit 300 controls the wafer chuck 170 to perform the first absorption step, the releasing step, and the second absorption step. The temperature of the wafer chuck 170 is maintained at a predetermined value.

The exposure device 140 is connected to a coating device 110 and a developing device 120 through an interface 125 for transporting the semiconductor wafer 200. The exposure device 140 further includes a pre-alignment unit 130 and a wafer moving mechanism 180. The pre-alignment unit 130 aligns the notch position (direction) of the semiconductor wafer 200. The wafer moving mechanism 180 transports the semiconductor wafer 200. The control unit 300 controls the exposure device 140 (including the wafer chuck 170), the coating device 110, and the developing device 120.

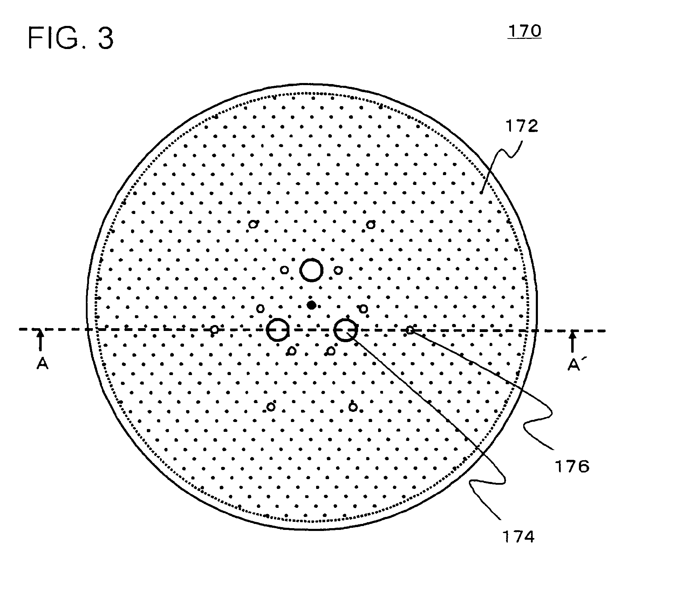

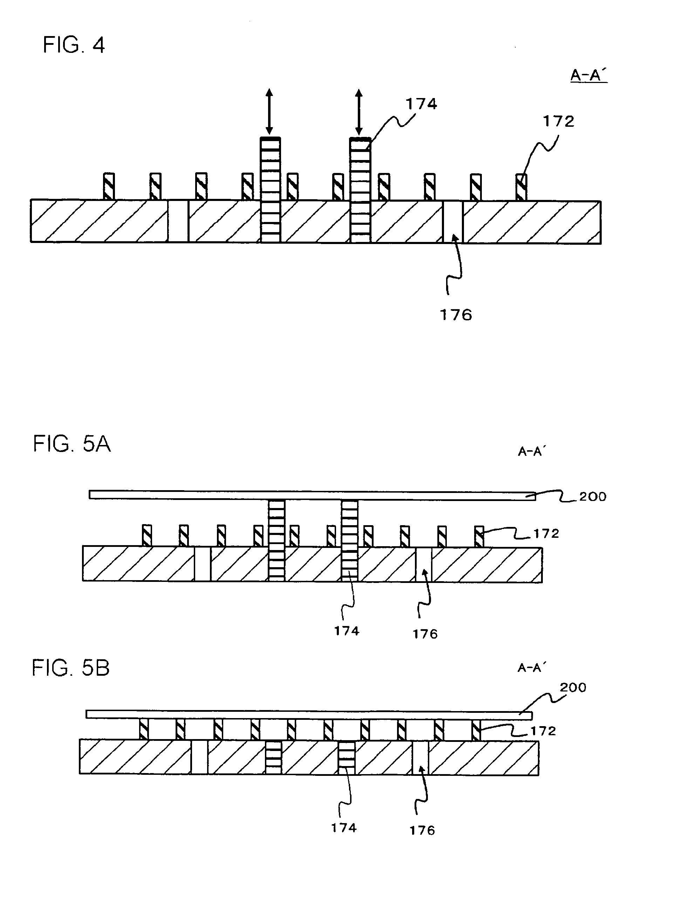

Fig. 3 is a plan view illustrating the wafer chuck 170, and Fig. 4 is a cross-sectional view taken along the line A-A' of Fig. 3. The wafer chuck 170 includes a plurality of supporting pins 172, a plurality of lift pins 174, and a plurality of absorption holes 176. The supporting pins 172 are provided substantially on the entire surface of the wafer chuck 170 so as to be uniformly distributed. The lift pins 174 are provided on a concentric circle of the wafer chuck 170 at regular intervals, and move up and down the semiconductor wafer 200 according to instructions from the control unit 300. The absorption holes 176 are provided on a concentric circle of the wafer chuck 170 at regular intervals. The diameter of the circle on which the lift pins 174 are arranged and the diameter of the circle on which the absorption holes 176 are arranged are smaller than that of the semiconductor wafer 200. In the example shown in Figs. 3 and 4, the absorption holes 176 are arranged on two circles with different diameters.

Figs. 5A and 5B are cross-sectional views illustrating the operation of the wafer chuck 170, and correspond to the cross-sectional view of Fig. 3 taken along the line A-A'. As shown in Fig. 5A, when the semiconductor wafer 200 is transported to the wafer chuck 170, the upper end of the lift pin 174 is higher than that of the supporting pin 172. In this state, when the semiconductor wafer 200 is transported, the semiconductor wafer 200 is supported by the lift pins 174.

As shown in Fig. 5B, when the lift pins 174 are moved down such that their upper ends are lower than the upper ends of the supporting pins 172, the semiconductor wafer 200 is supported by the supporting pins 172. In this state, when air is drawn through the absorption holes 176, the semiconductor wafer 200 is absorbed to the wafer chuck 170 while being supported by the supporting pins 172.

Then, when the drawing of air through the absorption holes 176 is completed and the lift pins 174 are moved up, the semiconductor wafer 200 is released from the wafer chuck 170.

Next, the method of manufacturing the semiconductor device according to this embodiment will be described in detail with reference to Fig. 1. First, the control unit 300 carries the semiconductor wafer 200 into the coating device 110, and controls the coating device 110 to form a resist film on the semiconductor wafer 200 (Step S10). Then, the control unit 300 controls the wafer moving mechanism 180 to transport the semiconductor wafer 200 to the pre-alignment unit 130 of the exposure device 140 through the interface 125. Then, the control unit 300 controls the pre-alignment unit 130 to pre-align the transported semiconductor wafer 200, thereby aligning a notch position (direction) with a reference position (Step S20).

Then, the control unit 300 controls the wafer moving mechanism 180 to transport the semiconductor wafer 200 from the pre-alignment unit 130 to the wafer stage 160. Then, the control unit 300 controls the wafer chuck 170 of the wafer stage 160 to absorb the semiconductor wafer 200 to the wafer chuck 170. This state is maintained for a predetermined period of time. Then, the temperature of the semiconductor wafer 200 is substantially equal to that of the wafer chuck 170 (Step S30). In this case, it is preferable that the holding time be equal to or more than, for example, 10 seconds. In this way, there is little temperature variation in the semiconductor wafer 200 when the semiconductor wafer 200 is absorbed to the wafer chuck 170. As a result, the semiconductor wafer 200 is hardly thermally expanded or contracted.

In this case, thermal expansion or thermal contraction is likely to occur in the semiconductor wafer 200 due to temperature variation after the semiconductor wafer 200 is absorbed to the wafer chuck 170. As shown in Fig. 5B, the semiconductor wafer 200 is absorbed to the wafer chuck 170 while being supported by the supporting pins 172 in Step S30. Therefore, even when the thermal expansion or thermal contraction occurs in the semiconductor wafer 200, a portion of the semiconductor wafer 200 supported by the supporting pins 172 is less likely to move. Therefore, an in-plane distribution is likely to occur in the thermal expansion or thermal contraction of the semiconductor wafer 200.

Then, the control unit 300 controls the wafer chuck 170 to release the semiconductor wafer 200 (S40). In this state, in Step S20, the in-plane distribution of the thermal expansion or thermal contraction occurring in the semiconductor wafer 200 is removed.

Then, the control unit 300 controls the wafer chuck 170 to absorb the semiconductor wafer 200 again (Step S50). Then, the control unit 300 controls the exposure device 140 to expose the resist film formed on the semiconductor wafer 200 (Step S60).

Then, the control unit 300 controls the wafer moving mechanism 180 to transport the semiconductor wafer 200 to the developing device 120 through the interface 125, and develops the resist film on the semiconductor wafer 200 (Step S70).

The process of the control unit 300 shown in Fig. 1 is implemented by installing a program for allowing the control unit 300 to perform the above-mentioned process. The control unit 300 includes, for example, a CPU, a memory, and a storage unit, such as a hard disk storing the above-mentioned program. The program is stored in the storage unit through, for example, a removable disk. However, the program may be downloaded through a communication line and then stored in the storage unit.

Next, the operation and effect of this embodiment will be described. As described above, the semiconductor wafer 200 is absorbed to the wafer chuck 170 while being supported by the supporting pins 172. Therefore, even when the semiconductor wafer 200 is thermally expanded or contracted after being absorbed to the wafer chuck 170, the portion of the semiconductor wafer 200 supported by the supporting pins 172 is less likely to move. Therefore, an in-plane distribution is likely to occur in the thermal expansion or thermal contraction of the semiconductor wafer 200. However, in this embodiment, before the exposure process (Step S60 in Fig. 1) is performed, the semiconductor wafer 200 is released from the wafer chuck 170 (Step S40 in Fig. 1). Therefore, the in-plane distribution of the thermal expansion or thermal contraction occurring in the semiconductor wafer 200 is removed before the exposure process. As a result, it is possible to prevent the positioning accuracy of the exposure device from being partially reduced.

### (second embodiment)

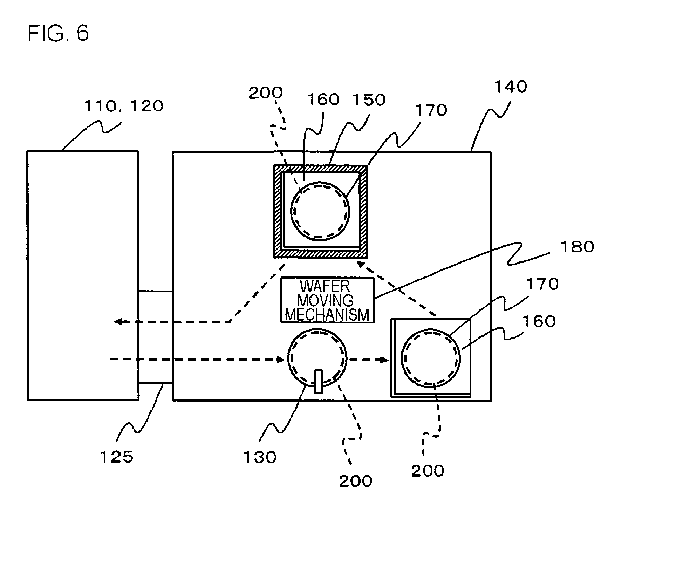

Fig. 6 is a diagram illustrating the structure of an exposure device 140 according to a second embodiment. In this embodiment, the exposure device 140 has the same structure as that in the first embodiment except that it includes two wafer stages 160. One of the two wafer stages 160 is provided on the exposure stage 150, similar to the first embodiment, and the other wafer stage 160 is provided at a different position from the exposure stage 150.

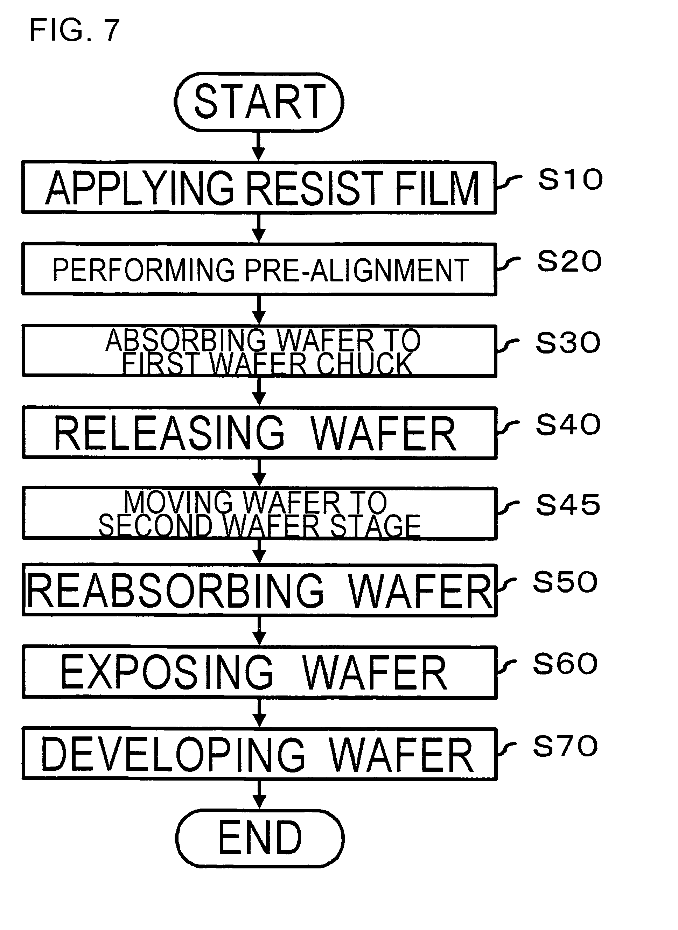

Fig. 7 is a flowchart illustrating a method of manufacturing a semiconductor device using the exposure device 140 shown in Fig. 6. The method of manufacturing the semiconductor device shown in Fig. 7 is the same as the method of manufacturing the semiconductor device according to the first embodiment except that the first absorption step of adjusting the temperature of the semiconductor wafer 200, the second absorption step, and the step of exposing the semiconductor wafer 200 are performed using different wafer stages 160. The wafer stages 160 are set to the same temperature.

That is, in Step S30, the control unit 300 controls the wafer stage 160 (first wafer stage) that is disposed at a different position from the exposure stage 150 to absorb the semiconductor wafer 200, and adjusts the temperature of the semiconductor wafer 200. In this case, it is preferable that the holding time is equal to or more than, for example, 10 seconds. In this way, there is little temperature variation in the semiconductor wafer 200 when the semiconductor wafer 200 is absorbed to the wafer chuck 170. As a result, the semiconductor wafer 200 is hardly thermally expanded or contracted. In Step S40, the semiconductor wafer 200 is released, and the semiconductor wafer 200 is moved to the wafer stage 160 (second wafer stage) on the exposure stage 150 (Step S45). Then, the semiconductor wafer 200 is absorbed to the wafer stage 160 on the exposure stage 150 (Step S50), and an exposure process is performed (Step S60).

The process of the control unit 300 shown in Fig. 7 is implemented by installing a program for allowing the control unit 300 to perform the above-mentioned process, similar to the first embodiment. The program is stored in a storage unit through, for example, a removable disk. However, the program may be downloaded through a communication line and then stored in the storage unit.

In this embodiment, it is possible to obtain the same effects as those in the first embodiment. While the exposure process is being performed, it is possible to adjust the temperature of the next semiconductor wafer 200 using the wafer stage 160 that is disposed at a different position from the exposure stage 150. Therefore, it is possible to prevent the process throughput of the semiconductor wafer 200 from being reduced.

### (third embodiment)

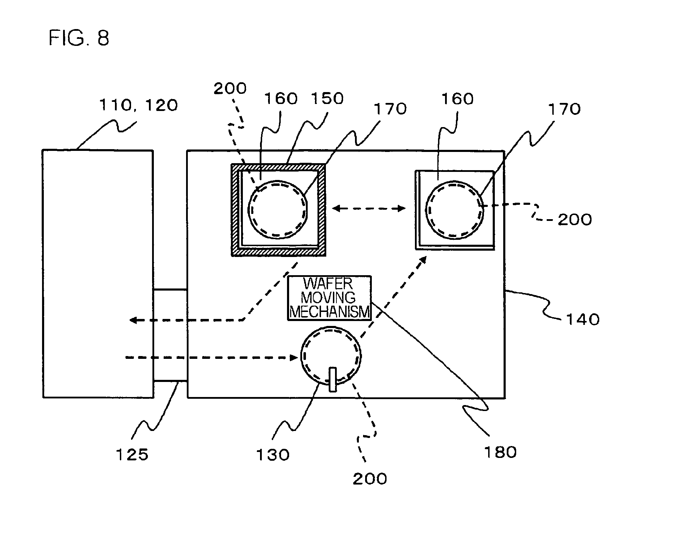

Fig. 8 is a diagram illustrating the structure of an exposure device 140 according to a third embodiment. In this embodiment, the exposure device 140 has the same structure as that in the first embodiment except that it includes a plurality of wafer stages 160. The plurality of wafer stages 160 is alternately moved onto the exposure stage 150. The plurality of wafer stages 160 is moved by a moving mechanism (not shown).

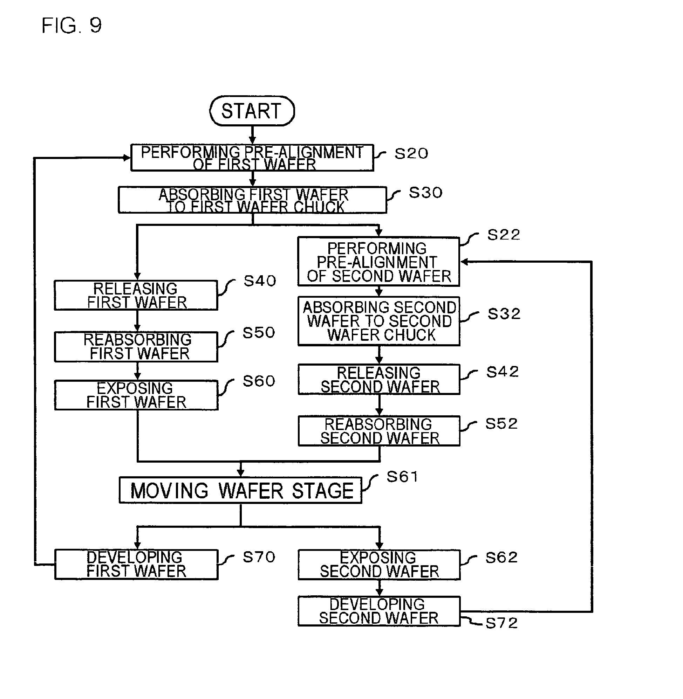

Fig. 9 is a flowchart illustrating a method of manufacturing a semiconductor device using the exposure device 140 shown in Fig. 8. The method of manufacturing the semiconductor device is the same as the method of manufacturing the semiconductor device according to the first embodiment except for the following.

First, while one wafer stage 160 is used to expose a first semiconductor wafer 200 (Step S60), the control unit 300 performs at least one of the first absorption step, the releasing step, and the second absorption step on a second semiconductor wafer 200 using another wafer stage 160.

Specifically, while one wafer stage 160 is used to perform a releasing step (Step S40), a reabsorption step (Step S50), and an exposure step (Step S60) on the first semiconductor wafer 200, the control unit 300 uses another wafer stage 160 to perform a notch positioning step by the pre-alignment unit 130 (Step S22), the first absorption step (Step S32), the releasing step (Step S42), and the second absorption step (Step S52) on the second semiconductor wafer 200. When the exposure step for the first semiconductor wafer 200 ends (Step S60) and the second absorption step for the second semiconductor wafer 200 ends (Step S52), the control unit moves the wafer stage 160 (Step S61).

Then, while the first semiconductor wafer 200 is being developed (Step S70), the control unit 300 exposes the second semiconductor wafer 200 (Step S62).

Then, when one wafer stage 160 is performing notch positioning on the next first semiconductor wafer 200 (Step S20), the control unit 300 develops the second semiconductor wafer 200 (Step S72).

The process of the control unit 300 shown in Fig. 9 is implemented by installing a program for allowing the control unit 300 to perform the above-mentioned process, similar to the first embodiment. The program is stored in a storage unit through, for example, a removable disk. However, the program may be downloaded through a communication line and then stored in the storage unit.

In this embodiment, it is possible to obtain the same effects as those in the first embodiment. In addition, since the exposure process or the development process, and other processes can be performed in parallel, it is possible to prevent the process throughput of the semiconductor wafer 200 from being reduced. Unlike the second embodiment, the first absorption step and the exposure step are performed by the same wafer stage 160. Therefore, it is possible to reduce the possibility that the in-plane distribution of thermal expansion or thermal contraction will occur in the semiconductor wafer 200 in the second absorption step, as compared to the second embodiment. In addition, in this embodiment, it is preferable that the holding time in the absorption step (Steps S30 and S32) for adjusting the temperature of the semiconductor wafer 200 be equal to or more than, for example, 10 seconds. In this way, there is little temperature variation in the semiconductor wafer 200 when the semiconductor wafer 200 is absorbed to the wafer chuck 170. As a result, the semiconductor wafer 200 is hardly thermally expanded or contracted.

The exemplary embodiments of the invention have been described above with reference to the accompanying drawings. However, it is apparent that the present invention is not limited to the above embodiments, but may be modified and changed without departing from the scope and spirit of the invention.

## Claims

1. A method of manufacturing a semiconductor device, comprising:
allowing a wafer chuck of a first wafer stage to absorb a semiconductor wafer to adjust the temperature of said semiconductor wafer;
releasing said semiconductor wafer from said wafer chuck;
allowing a wafer chuck of a wafer stage for exposure to absorb said semiconductor wafer; and
exposing said semiconductor wafer.

2. The method of manufacturing a semiconductor device as set forth in claim 1,
wherein said wafer stage for exposure is said first wafer stage.

3. The method of manufacturing a semiconductor device as set forth in claim 2,
wherein a plurality of first wafer stages is provided, and
while one of said first wafer stages is used to perform said step of exposing said semiconductor wafer, another first wafer stage is used to perform at least one of said step of allowing said wafer chuck of said first wafer stage to absorb said semiconductor wafer to adjust the temperature of said semiconductor wafer, said step of releasing said semiconductor wafer from said wafer chuck and said step of allowing said wafer chuck of said wafer stage for expose to absorb said semiconductor wafer.

4. The method of manufacturing a semiconductor device as set forth in claim 1,
wherein said wafer stage for exposure is a second wafer stage different from said first wafer stage.

5. A program that is installed in a control unit of an exposure device including a wafer chuck which absorbs a semiconductor wafer and said control unit which controls said wafer chuck, said program causes said control unit to perform, before an exposure process:
a first absorption process of allowing said wafer chuck to absorb said semiconductor wafer to adjust the temperature of said semiconductor wafer;
a releasing process of releasing said semiconductor wafer from said wafer chuck; and
a second absorption process of allowing said wafer chuck to reabsorb said semiconductor wafer.

6. The program as set forth in claim 5,
wherein said exposure device includes a plurality of wafer chucks, and
while one of said wafer stages is used to perform said exposure process, the program causes said control unit to perform at least one of said first absorption process, said releasing process, and said second absorption process using another wafer stage.

7. A program that is installed in a control unit of an exposure device comprising a first wafer stage including a first wafer chuck which absorbs a semiconductor wafer, a second wafer stage for exposure including a second wafer chuck which absorbs said semiconductor wafer, a wafer moving mechanism which moves said semiconductor wafer, and said control unit which controls said wafer moving mechanism, said first wafer chuck, and said second wafer chuck, and causes said control unit to perform, before an exposure process:
a process of allowing said first wafer chuck of said first wafer stage to absorb said semiconductor wafer to adjust the temperature of said semiconductor wafer;
a process of allowing said first wafer chuck to release said semiconductor wafer;
a process of allowing said wafer moving mechanism to move said semiconductor wafer over said first wafer stage to said second wafer stage; and
a process of allowing said second wafer chuck of said second wafer stage to absorb said semiconductor wafer.

8. An exposure device comprising:
a wafer chuck that absorbs a semiconductor wafer; and
a control unit that controls said wafer chuck,
wherein, before an exposure process, said control unit performs a first absorption process of allowing said wafer chuck to absorb said semiconductor wafer to adjust the temperature of said semiconductor wafer, a releasing process of allowing said wafer chuck to release said semiconductor, and a second absorption process of allowing said wafer chuck to reabsorb said semiconductor wafer.

9. The exposure device as set forth in claim 8,
wherein a plurality of wafer chucks is provided, and
while one of said wafer chucks is used to perform said exposure process, said control unit performs at least one of said first absorption process, said releasing process, and said second absorption process using another wafer chuck.

10. An exposure device comprising:
a first wafer stage including a first wafer chuck that absorbs a semiconductor wafer;
a second wafer stage for exposure including a second wafer chuck which absorbs said semiconductor wafer;
a wafer moving mechanism that moves said semiconductor wafer; and
a control unit that controls said wafer moving mechanism, said first wafer chuck, and said second wafer chuck,
wherein said control unit performs a process of allowing said first wafer chuck of said first wafer stage to absorb said semiconductor wafer to adjust the temperature of said semiconductor wafer, a process of allowing said first wafer chuck to release said semiconductor wafer, a process of allowing said wafer moving mechanism to move said semiconductor wafer over said first wafer stage to said second wafer stage, and a process of allowing said second wafer chuck of said second wafer stage to absorb said semiconductor wafer.

11. A recording medium comprising a program stored therein that is installed in a control unit of an exposure device including a wafer chuck which absorbs a semiconductor wafer and said control unit which controls said wafer chuck, said program causes said control unit to perform, before an exposure process:
a first absorption process of allowing said wafer chuck to absorb said semiconductor wafer to adjust the temperature of said semiconductor wafer;
a releasing process of allowing said wafer chuck to release said semiconductor wafer; and
a second absorption process of allowing said wafer chuck to reabsorb said semiconductor wafer.

12. The recording medium as set forth in claim 11,
wherein said exposure device includes a plurality of said wafer chucks, and
while one of said wafer chucks is used to perform said exposure process, said program causes said control unit to perform at least one of said first absorption process, said releasing process, and said second absorption process using another wafer chuck.

13. A recording medium comprising a program stored therein that is installed in a control unit of an exposure device including a first wafer stage including a first wafer chuck which absorbs a semiconductor wafer, a second wafer stage for exposure including a second wafer chuck which absorbs said semiconductor wafer, a wafer moving mechanism which moves said semiconductor wafer, and said control unit which controls said wafer moving mechanism, said first wafer chuck, and said second wafer chuck, said program causes said control unit to perform, before an exposure process:
a process of allowing said first wafer chuck of said first wafer stage to absorb said semiconductor wafer to adjust the temperature of said semiconductor wafer;
a process of allowing said first wafer chuck to release said semiconductor wafer;
a process of allowing said wafer moving mechanism to move said semiconductor wafer over said first wafer stage to said second wafer stage; and a process of allowing said second wafer chuck of said second wafer stage to absorb said semiconductor wafer.
